Europäisches Patentamt

European Patent Office

Office européen des brevets

(19)

(11) EP 1 102 328 A1

(12) ## DEMANDE DE BREVET EUROPEEN

(43) Date de publication:
**23.05.2001 Bulletin 2001/21**

(51) Int Cl.⁷: **H01L 29/92**

(21) Numéro de dépôt: **00123636.3**

(22) Date de dépôt: **30.10.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **18.11.1999 FR 9914480**

(71) Demandeur: **FRANCE TELECOM**
**75015 Paris (FR)**

(72) Inventeurs:
• **Delpech, Philippe**
**38240 Meylan (FR)**
• **Arnal, Vincent**
**46210 Saint Cirgues (FR)**

(74) Mandataire: **Marchand, André**
**OMNIPAT,**
**24 Place des Martyrs de la Résistance**
**13100 Aix-en-Provence (FR)**

(54) **Capacité intégrée à diélectrique hybride**

(57)   L'invention concerne une capacité (20) intégrée sur un substrat de silicium (10), comprenant des couches (1, 3) de première et de deuxième électrodes et un diélectrique (2). Selon l'invention, le diélectrique comprend au moins deux couches (2-1, 2-2) de diélectriques ayant des permittivités (ε) évoluant de façon opposée en fonction du champ électrique, le rapport des épaisseurs (d1, d2) de chaque couche diélectrique étant choisi de manière que la capacité présente une linéarité en tension satisfaisante. L'invention concerne également une combinaison de deux capacités comportant des diélectriques différents ayant des permittivités évoluant de façon opposée en fonction du champ électrique.

FIG.3D

EP 1 102 328 A1

## Description

La présente invention concerne les circuits intégrés et plus particulièrement les capacités intégrées sur substrat de silicium.

A l'heure actuelle, il est de pratique courante de réaliser des circuits intégrés pourvus d'une ou plusieurs capacités intégrées de forte valeur, remplaçant avantageusement les condensateurs conventionnels se présentant sous forme de composants discrets. De telles capacités trouvent diverses applications dans le domaine des circuits analogiques et des circuits RF, par exemple pour le filtrage des tensions d'alimentation, la réalisation de circuits d'antenne résonants, etc..

Parmi les capacités intégrées connues, les capacités à électrodes métalliques présentent de nombreux atouts par rapport aux capacités à électrodes en silicium polycristallin, notamment pour les applications en analogique plutôt qu'en numérique.

D'une part, les électrodes métalliques présentent une excellente conductivité électrique alors que les électrodes en silicium polycristallin nécessitent, à cet effet, un traitement de siliciuration en présence d'un métal comme du tungstène ou du titane.

D'autre part, les capacités à électrodes métalliques sont d'une grande simplicité de fabrication, l'électrode inférieure étant généralement réalisée à partir de l'une des dernières couches métalliques des circuits intégrés, par exemple une couche métallique servant à réaliser des pistes conductrices. Ainsi, au regard du procédé habituel de fabrication des circuits intégrés, la réalisation d'une capacité à électrodes métalliques ne nécessite qu'une étape de dépôt d'une couche de diélectrique sur une couche métallique préexistante, utilisée en tant que couche de première électrode, et une étape de dépôt d'une couche métallique de deuxième électrode. Le diélectrique est déposé à une température modérée de l'ordre de 400°C afin de ne pas endommager la couche métallique de première électrode.

Enfin, les capacités à électrodes métalliques présentent une faible capacité parasite par rapport au substrat de silicium, du fait qu'elles sont réalisées, comme on vient de l'indiquer, sur l'un des derniers niveaux des circuits intégrés.

Toutefois il s'avère en pratique que les capacités à électrodes métalliques présentent une linéarité en tension médiocre, la linéarité en tension étant définie par le rapport $\Delta C/C$ dans lequel C désigne la capacité à tension nulle et $\Delta C$ les variations de la capacité avec la tension appliquée. Le rapport $\Delta C/C$ d'une capacité à électrodes métalliques est typiquement de l'ordre de $200\ 10^{-6}$/V, soit un défaut de linéarité au moins 10 fois supérieur à la valeur généralement tolérée par les concepteurs de circuits intégrés analogiques.

Pour cette raison, les capacités à électrodes métalliques, malgré les avantages rappelés ci-dessus, ne connaissent à l'heure actuelle que peu d'applications dans le domaine des circuits analogiques et des circuits RF

Au terme de diverses études, les auteurs de la présente invention ont émis l'hypothèse que le phénomène de non-linéarité précité, qui ne se manifeste que faiblement dans les capacités à électrodes en silicium polycristallin, est lié au fait que le diélectrique est déposé à une température modérée, entraînant l'incorporation de nombreux atomes d'impuretés (H, N, C...) et la création de nombreux états d'interface, généralement des liaisons pendantes. En outre, les capacités à électrodes métalliques, contrairement aux capacités à électrodes en silicium polycristallin, ne sont pas soumises à une étape de recuit à haute température, réalisée classiquement à une température de l'ordre de 850°C pendant plusieurs dizaines de minutes. Rappelons en effet que dans le processus classique de fabrication des circuits intégrés, les étapes classiques de recuit pour l'activation des dopants sont toujours réalisées avant le dépôt des couches métalliques afin de ne pas endommager ces dernières.

Ainsi, il apparaît que la médiocre linéarité en tension des capacités à électrodes métalliques est liée à la présence d'impuretés dans le diélectrique et/ou à une formation incomplète du diélectrique, qu'un recuit à haute température fait en partie disparaître.

Ceci est confirmé par les relations (1) à (3) ci-après, qui donnent respectivement la valeur d'une capacité électrique C en fonction de la permittivité absolue $\varepsilon$ du diélectrique, et la valeur de la permittivité $\varepsilon$ du diélectrique en fonction de la tension V ou du champ électrique E appliqué à la capacité :

$$(1)\ C = \varepsilon\ S/d$$

avec :

$$(2)\ \varepsilon = \varepsilon_0 + A + B\ E^2$$

soit :

$$(3)\ \varepsilon = \varepsilon_0 + A + B\ V^2/d^2$$

S étant la surface des électrodes de la capacité, *d* la distance entre les électrodes ou épaisseur du diélectrique, $\varepsilon_0$ la permittivité du vide, A une constante et B un terme quadratique multiplié par le carré de la tension appliquée.

Ainsi, il est clair que les variations d'une capacité en fonction de la tension sont dues aux variations de la permittivité $\varepsilon$ de son diélectrique, et plus particulièrement à l'existence du terme quadratique B.

Le terme quadratique B est généralement très petit devant la constante A. Toutefois, l'épaisseur d du diélectrique d'une capacité intégrée est très faible, de l'ordre de quelques dizaines de nanomètres, et supporte une tension de quelques volts. Dans ces conditions, le champ électrique E, égal à V/*d,* est très élevé et l'effet du terme quadratique n'est plus négligeable. Par exemple, une capacité ayant un diélectrique d'une épaisseur de 30 nm soumise à une tension de 3V supporte un champ électrique très élevé de $10^8$V/m.

Ainsi, l'objectif général de la présente invention est de prévoir une capacité intégrée analogique à électrodes métalliques présentant une linéarité en tension satisfaisante n'excédant pas 20 $10^{-6}$/V sans nécessairement prévoir une étape de recuit à haute température, ainsi qu'un procédé de fabrication de cette capacité.

Cet objectif est atteint par la prévision d'une capacité à électrodes métalliques intégrée sur un substrat de silicium, comprenant des couches métalliques de première et de deuxième électrodes et un diélectrique, dans laquelle le diélectrique comprend au moins deux couches de diélectriques ayant des permittivités évoluant de façon opposée en fonction du champ électrique, le rapport des épaisseurs de chaque couche diélectrique étant choisi de manière que la capacité présente une linéarité en tension satisfaisante n'excédant pas 20 $10^{-6}$/V.

Selon un mode de réalisation, le diélectrique comprend une couche d'oxyde de silicium et une couche de nitrure de silicium.

Selon un mode de réalisation, les couches de diélectriques sont séparées par une couche conductrice intercalaire.

Selon un mode de réalisation, le matériau constituant les couches de première et de deuxième électrodes est choisi dans le groupe comprenant l'aluminium, le cuivre, le tungstène, le titane, le nitrure de titane et leurs alliages.

La présente invention concerne également une combinaison d'au moins deux capacités à électrodes métalliques intégrées sur un substrat de silicium, dans laquelle les capacités comportent des diélectriques différents ayant des permittivités évoluant de façon opposée en fonction du champ électrique, le rapport des épaisseurs de chaque diélectrique étant choisi de manière que la capacité résultante formée par la combinaison présente une linéarité en tension satisfaisante n'excédant pas 20 $10^{-6}$/V.

La combinaison peut comprendre au moins deux capacités en série ou au moins deux capacités en parallèle.

Selon un mode de réalisation, le diélectrique d'une capacité est de l'oxyde de silicium et le diélectrique de l'autre capacité est du nitrure de silicium.

La présente invention concerne également un procédé de fabrication d'une capacité à électrodes métalliques intégrée sur un substrat de silicium, comprenant une étape de dépôt d'une couche métallique de première électrode, une étape de dépôt d'un diélectrique, et une étape de dépôt d'une couche métallique de deuxième électrode, l'étape de dépôt du diélectrique comprenant au moins une étape de dépôt d'une couche d'un premier diélectrique et une étape de dépôt d'une couche d'un deuxième diélectrique, les premier et deuxième diélectriques ayant des permittivités évoluant de façon opposée en fonction du champ électrique, le rapport des épaisseurs de chaque couche de diélectrique étant choisi de manière que la capacité présente une linéarité en tension satisfaisante n'excédant pas 20 $10^{-6}$/V.

Selon un mode de réalisation, le rapport des épaisseurs de chaque couche diélectrique est déterminé par des essais préalables, en observant la linéarité en tension de capacités de test comprenant des rapports d'épaisseurs différents.

Selon un mode de réalisation, les diélectriques sont de l'oxyde de silicium et du nitrure de silicium.

Selon un mode de réalisation, les couches de diélectriques sont déposées en phase vapeur.

Selon un mode de réalisation, les couches de première et de deuxième électrodes sont constituées par un matériau choisi dans le groupe comprenant l'aluminium, le cuivre, le tungstène, le titane, le nitrure de titane et leurs alliages.

Ces objets, caractéristiques et avantages de l'invention seront exposés plus en détail dans la description suivante d'un procédé de fabrication d'un diélectrique selon l'invention et d'une capacité comportant un tel diélectrique, en relation avec les figures jointes parmi lesquelles :

- la figure 1 représente la courbe de non-linéarité en tension d'une capacité à oxyde de silicium classique,

- la figure 2 représente la courbe de non-linéarité en tension d'une capacité à nitrure de silicium classique,

- les figures 3A à 3D représentent schématiquement par des vues en coupe des étapes de fabrication d'une capacité selon l'invention, et

- la figure 4 représente des courbes de non-linéarité en tension de capacités selon l'invention.

**Fondements de l'invention**

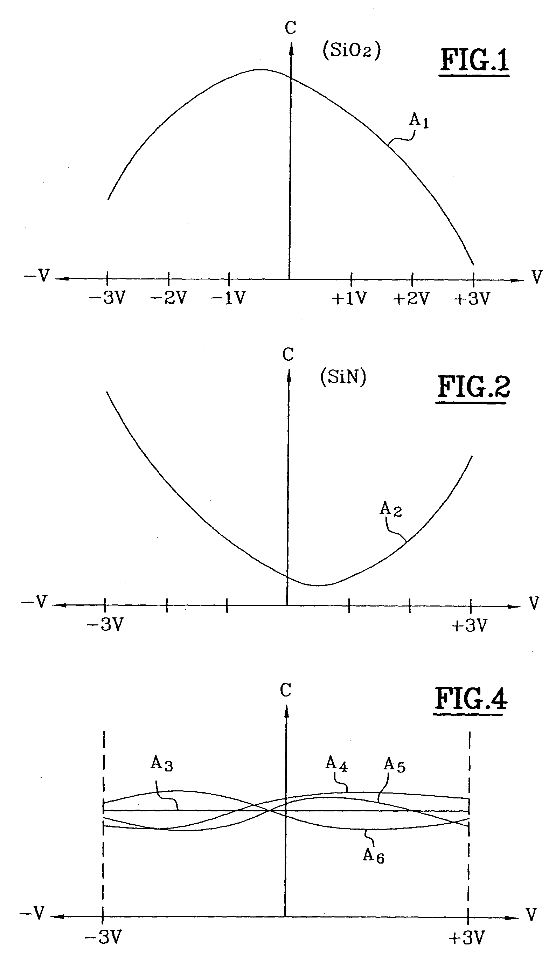

La présente invention repose sur la constatation selon laquelle certains diélectriques ont des permittivités qui évolue de façon inverse en fonction de la tension appliquée. Une telle constatation ressort de la comparaison des deux diélectriques les plus utilisés dans l'industrie du semi-conducteur, à savoir l'oxyde de silicium Si02 et le nitrure de silicium SiN. Pour fixer les idées, les figures 1 et 2 représentent schématiquement sous la forme de deux courbes A1, A2 les variations en fonction de la tension V d'une capacité C1 à oxyde de silicium et d'une capacité C2 à nitrure de silicium. Il apparaît nettement que les courbes A1, A2, en forme de paraboles, sont opposées l'une à l'autre, les deux branches de la courbe A1 étant orientées vers le bas alors que les branches de la courbe A2 sont orientées vers le haut.

Pour expliquer ce phénomène, on définit le terme quadratique B d'un diélectrique [voir préambule relations (2) et (3)] comme la résultante de deux termes $B_{ani}$ et $B_{pol}$ qui dépendent des grandeurs microscopiques du diélectrique :

$$(4)\ B = (B_{ani} - B_{pol})$$

$B_{ani}$ représentant la contribution de l'anisotropie moléculaire du diélectrique, et $B_{poli}$ la contribution des dipôles permanents du diélectrique.

Ceci est dû au fait que, sous l'action d'un champ électrique, le diélectrique se polarise et que plusieurs effets se superposent : polarisation ionique, polarisation électronique et polarisation dipolaire. Ces effets sont particulièrement sensibles avec les diélectriques basse température n'ayant pas subi de recuit thermique.

Ainsi, certains diélectriques ont un terme $B_{ani}$ prédominant sur le terme $B_{pol}$ et d'autres diélectriques ont un terme $B_{pol}$ prédominant sur le terme $B_{ani}$. Notamment, les courbes A1, A2 des figures 1, 2 montrent que l'oxyde de silicium présente un terme quadratique B négatif alors que le nitrure de silicium présente un terme quadratique B positif.

Sur la base de cette constatation, l'idée de la présente invention est de combiner deux diélectriques ayant des termes quadratiques B de signes opposés, pour obtenir un diélectrique ayant un terme quadratique résultant qui soit aussi petit que possible.

Plus particulièrement, la présente invention prévoit un diélectrique comprenant au moins deux couches de diélectriques ayant des propriétés opposées, de manière que les variations de la permittivité d'une couche de diélectrique compensent les variations de la permittivité de l'autre couche de diélectrique.

**Exemple de mise en oeuvre de l'invention**

A titre d'exemple non limitatif, on décrira l'application de l'invention à la réalisation d'une capacité intégrée ayant un diélectrique basse température hybride, comprenant une couche d'oxyde de silicium $SiO_2$ et une couche de nitrure de silicium SiN.

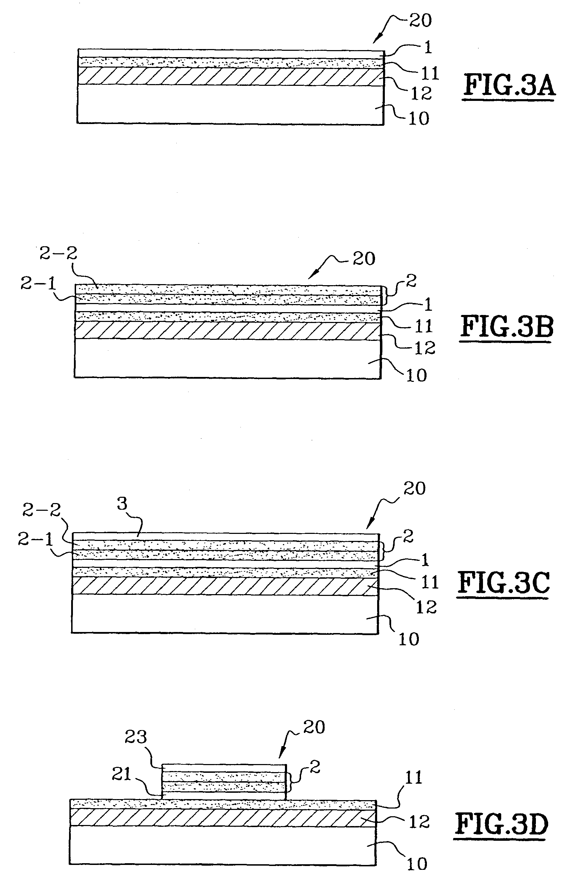

La figure 3A est une vue en coupe partielle d'un circuit intégré en cours de fabrication, dans une zone du circuit intégré où une capacité 20 à électrodes métalliques doit être réalisée. A ce stade de la fabrication, la capacité 20 ne comporte qu'une couche métallique de première électrode 1 déposée sur un substrat de silicium 10 par l'intermédiaire d'une couche électriquement isolante 11. Comme on l'a indiqué au préambule, cette couche de première électrode 1 est par exemple l'une des dernières couches de métal du circuit intégré, par exemple la couche "Métal 4", "Métal 5", "Métal 6"... selon la structure du circuit intégré et le nombre de niveaux conducteurs qu'il comporte. Ainsi, entre la couche de première électrode 1 et le substrat 10 proprement dit, peuvent se trouver d'autres couches de circuit intégré, notamment des couches métalliques séparées par des couches isolantes, représentées schématiquement par une région 12 en traits hachurés.

La couche métallique de première électrode 1, par exemple en aluminium (Al), est déposée classiquement sous vide au moyen d'une vapeur de métal.

L'étape illustrée sur la figure 3B caractérise le procédé de l'invention et consiste à déposer successivement sur la couche de première électrode 1 une couche 2-1 d'oxyde de silicium d'épaisseur dl et une couche 2-2 de nitrure de silicium d'épaisseur d2, ou inversement, l'ensemble formant une couche équivalente de diélectrique 2 d'épaisseur d1+d2.

Le dépôt de chaque couche de diélectrique est réalisé au moyen de la technique classique PECVD ("Plasma Enhanced Chemical Vapour Deposition", ou dépôt en phase vapeur amélioré par plasma) dans un réacteur industriel standard, par exemple le réacteur commercialisé sous la référence DXZ par la société *Applied Materials.*

Le dépôt de chaque couche 2-1, 2-2 est réalisé sous vide à une température de l'ordre de 400°C, en présence d'un plasma, en combinant les gaz utilisés classiquement pour déposer de l'oxyde de silicium Si02 puis les gaz utilisés classiquement pour déposer le nitrure de silicium SiN. Ces gaz sont par exemple :

- pour le dépôt d'oxyde de silicium $SiO_2$, le silane $SiH_4$ et le gaz N20 (une molécule complexe comme le TEOS, ou Tetra-Ethyl-Ortho-Silicate, peut également être employée),
- pour le dépôt de nitrure SiN de silicium, le silane $SiH_4$, l'ammoniaque $NH_3$ et l'azote $N_2$.

De préférence, les conditions de dépôt de chaque couche 2-1, 2-2 (pression, température, débit des gaz, nature et intensité du plasma,...) sont fixées une fois pour toutes et les épaisseurs dl, d2 de chaque couche 2-1, 2-2 ne dépendent plus que de la durée de chaque étape de dépôt.

Avant de se lancer dans une production industrielle de capacités selon l'invention, le rapport d1/d2 des épaisseurs des couches 2-1, 2-2, qui est un paramètre essentiel pour l'obtention du résultat visé, est déterminé de façon expérimentale en réalisant une campagne d'essais. Cette campagne d'essais vise à rechercher le rapport d1 $(SiO_2)$ /d2 (SiN) ou d1(SiN)/d2($SiO_2$) le plus stable, par une analyse de la linéarité en tension de diverses capacités de test. Une fois la bonne combinaison trouvée, le paramètre d1/d2 est consigné et utilisé dans le processus industriel.

Par exemple, les essais conduits par la demanderesse sur les capacités à électrodes en aluminium ont conduit à réaliser un diélectrique dans lequel :

$$d1(SiO_2)/d2(SiN) = 30 \text{ nm}/30nm = 1$$

Les capacités ainsi réalisées présentent une linéarité en tension ramenée à des valeurs satisfaisantes de l'ordre de 20 $10^{-6}$/V soit une réduction par un facteur 10 de la non-linéarité constatée sur des capacités classiques en oxyde de silicium $SiO_2$, en nitrure de silicium SiN, ou en oxynitrure de silicium SiON.

Comme illustré sur la figure 3C, on dépose ensuite sur la couche diélectrique 2 une couche métallique de deuxième électrode 3, dont la composition peut être identique à celle de la couche de première électrode 1. La couche de première électrode 1 présente classiquement une épaisseur de l'ordre de 500 nanomètres, la couche diélectrique 2 présente une épaisseur d1 + d2 de l'ordre de quelques dizaines de nanomètres, et la couche de deuxième électrode 3 présente une épaisseur de l'ordre 150 nanomètres.

Comme illustré sur la figure 3D, les couches 1, 3 de première et de deuxième électrodes sont ensuite gravées, en commençant par la couche de deuxième électrode 3, de manière à faire apparaître une structure de condensateur 20 ayant des électrodes 21, 23 de dimensions désirées. En pratique, la surface des électrodes 21, 23 peut varier dans de grandes proportions selon la valeur souhaitée de la capacité et aller du micromètre carré au millimètre carré.

De façon générale, une capacité selon l'invention présente une courbe C = f(V) peu sensible à la tension V, qui résulte de la combinaison des courbes paraboliques A1, A2 représentées sur les figures 1 et 2. Cette courbe est par exemple l'une des courbes A4, A5, A6 représentées sur la figure 4, qui restent au voisinage de la courbe plate idéale A3 d'une capacité ayant un diélectrique parfait.

Bien entendu, les épaisseurs d1 et d2 mentionnées ci-dessus ne sont données qu'à titre d'exemple et sont susceptibles de modifications en fonction de divers paramètres du processus de fabrication, de la valeur de capacité surfacique souhaitée, et du matériau utilisé pour réaliser les couches de première et de deuxième électrodes.

D'autre part, outre l'aluminium (Al), les couches de première et de deuxième électrodes peuvent être constituées de divers métaux ou alliages connus, par exemple l'aluminium-cuivre (Al-Cu), le cuivre (Cu), le tungstène (W), le titane (Ti), le nitrure de titane (TiN), et leurs alliages.

Par ailleurs, bien que l'invention ait été réalisée pour résoudre le problème de la non-linéarité en tension des capacités analogiques comportant un diélectrique basse température n'ayant pas subi de traitement thermique, on trouve dans ce qui précède un enseignement général applicable à tous types de capacités. La présente invention est également applicable aux capacités des transistors MOS, aux capacités des cellules mémoire DRAM et aux capacités des cellules mémoire EEPROM.

Par ailleurs, bien qu'en l'état actuel de ses expérimentations la demanderesse se soit limitée à la réalisation d'un diélectrique $SiO_2$/SiN ou SiN/$SiO_2$ qui apporte entière satisfaction, il entre dans le cadre de la présente invention et il est à la portée de l'homme de l'art d'étendre le champ d'expérimentation de l'invention à tous autres diélectriques connus, notamment le pentoxyde de tantale $Ta_2O_5$, l'oxynitrure de silicium SiON, et à tous types de combinaisons de deux, voire trois de quatre diélectriques.

Il entre également dans le cadre de la présente invention de séparer les deux couches de diélectriques 2-1, 2-2 par une couche conductrice intercalaire. Ce mode de réalisation est équivalent à deux capacités en série ayant des diélectriques se compensant mutuellement, si les électrodes 1, 3 sont utilisées de façon classique en tant qu'anode et cathode de la capacité. Si, par contre, l'électrode intercalaire est utilisée comme anode ou cathode et que les électrodes 1, 3 sont connectées ensemble, ce mode de réalisation est équivalent à deux capacités en parallèle.

**Extension de l'invention à la réalisation d'une capacité complexe**

Pour fixer les idées sur la portée de la présente invention, on analysera ci-après le cas général d'une capacité complexe comprenant deux capacités C1, C2 comportant des diélectriques évoluant de façon inverse avec la tension. Une telle capacité peut résulter de la superposition de deux couches diélectriques avec ou sans électrode intercalaire ou comprendre deux capacités distinctes en série ayant des diélectriques opposés. On examinera également le cas d'une capacité complexe comprenant deux capacités C1, C2 en parallèle comportant des diélectriques évoluant de façon inverse avec la tension.

Capacités en série

Dans ce cas, la capacité résultante est égale à :

$$\text{(5) } C_R = C1\,C2/(C1 + C2)$$

Après application d'une tension, la capacité $C_R$ est égale à :

$$\text{(6) } C_R + \Delta C_R = (C1+\Delta C1) * (C2+\Delta C2)/[(C1+\Delta C1) + (C2+\Delta C2)]$$

soit :

$$\text{(7) } C_R+\Delta C_R = (C1C2+C1\Delta C2+C2\Delta C1_+\Delta C1\Delta C2) / [(C1+C2) + (\Delta C1+\Delta C2)]$$

Si, comme on le souhaite, la variation ACR est nulle, il vient que la relation (7) doit être égale à la relation (5), ce qui donne :

$$\text{(8) } \Delta C2C1^2 + \Delta C1C2^2 + (\Delta C1\Delta C2)C1 + (\Delta C1\Delta C2)C2 = 0$$

Les variations AC1 et AC2 étant très faibles devant Ci et C2, le terme du second ordre $\Delta C1\Delta C2$ peut être négligé et la relation (8) s'écrit :

$$\text{(9) } \Delta C2C1^2 + \Delta C1C2^2 = 0$$

La relation (9) confirme que la variation $\Delta C_R$ de la capacité résultante ne peut être nulle que si les variations $\Delta C_1$ et $\Delta C_2$ sont de signe opposées, de sorte que l'emploi de diélectriques ayant des propriétés opposées s'impose, conformément à l'invention.
Par ailleurs, en combinant les relations (1) et (3) données au préambule, il vient que :

$$\text{(10) } C1 = (\varepsilon_0 + A_1 + B_1\ V^2/d_1^2)\ S_1/d_1^2$$

de sorte que les variations $\Delta C1$ de C1 avec la tension V peuvent s'écrire :

$$\text{(11) } \Delta C1 = S_1B_1\ V^2/d_1^4$$

soit :

$$\text{(12) } \Delta C1 = K1\ V_1^2$$

K1 étant une constante et V1 la tension appliquée à la capacité C1.

De la même manière, les variations AC2 de C2 avec la tension V peuvent s'écrire :

$$(13)\ \Delta C2 = K2\ V_2^{\,2}$$

K2 étant une constante de signe opposé à K1, puisque les diélectriques de chacune des capacités C1, C2 ont des termes quadratiques $B_1$, $B_2$ de signes opposés.

En combinant les relations (9), (12) et (13), il vient que :

$$(14)\ K2V_2^{\,2}\ C1^2 + K1V_1^{\,2}\ C2^2 = 0$$

soit :

$$(15)\ C1^2/C2^2 = -(K1/K2)\ (V_1/V_2)$$

Les deux capacités étant en série, le rapport des tensions $V_1$ et V2 est égal à :

$$(16)\ V1/V2 = C2/C1$$

La relation (15) peut donc s'écrire :

$$(16)\ C1^3/C2^3 = -\ K1/K2$$

La relation (16) confirme qu'il existe au moins, pour une valeur CR souhaitée, un couple de valeurs Cl, C2 pour lequel les variations ACR de la capacité résultante CR sont nulles. En pratique, ce couple de valeur est déterminé implicitement dans le procédé décrit plus haut lorsque l'on recherche une combinaison d'épaisseurs dl/d2 donnant une capacité variant peu avec la tension appliquée. Si deux capacités distinctes sont agencées en série, la recherche de ce couple de valeurs peut également être déterminé par une combinaison S1/S2 des surfaces respectives des électrodes des deux capacités.

**Capacités en parallèle**

Il reste maintenant à s'assurer que le résultat selon l'invention peut également être obtenu par l'agencement en parallèle de deux capacités C1, C2 comportant des diélectriques évoluant de façon inverse avec la tension.

Dans ce cas, la capacité résultante est égale à :

$$(16)\ C_R = C1 + C2$$

Après application d'une tension, la capacité CR devient égale à :

$$(17)\ C_R + \Delta C_R = (C1 + \Delta C1) + (C2 + \Delta C2)$$

soit :

$$(18)\ C_R + \Delta C_R = C1 + C2 + \Delta C1 + \Delta C2$$

Si, comme on le souhaite, la variation $\Delta C_R$ est nulle, il vient que :

$$(19)\ \Delta C1 = -\ \Delta C2$$

En combinant la relation (19) avec les relations (12) et (13), il vient que :

$$(20)\ K1 = K2$$

avec :

$$(21)\ K1 = S_1B_1\ /d1^4$$

$$(22)\ K2 = S_2B_2\ /d2^4$$

soit :

$$(23)\ S_1B_1\ /d_1^4 = S_2B_2\ /d_2^4$$

soit :

$$(24)\ d1/d2 = \text{Fonction}(S1, S_2, B_1, B_2) = \text{Constante}$$

La relation (23) ou (24) confirme qu'il existe au moins, pour une valeur $C_R$ souhaitée, un couple de valeurs C1, C2 pour lequel les variations $\Delta C_R$ de la capacité résultante $C_R$ sont nulles. Des expérimentations peuvent permettre de déterminer, pour des surfaces S1, S2 données, le rapport d1/d2, afin de faciliter la conception des capacités C1 et C2 à partir d'une valeur $C_R$ recherchée.

**Conclusion**

En conclusion, il apparaît que le champ d'application de l'invention s'étend non seulement à la réalisation d'une capacité ayant au moins deux diélectriques superposés, mais également à la réalisation d'une capacité complexe comprenant au moins deux capacités en série ou en parallèle. Notons enfin que la capacité à deux diélectriques décrite plus haut ne constitue qu'un mode de réalisation particulier d'une capacité complexe comprenant deux capacités en série ayant des électrodes de même surface, comme cela est confirmé par les résultats obtenus par la demanderesse.

**Revendications**

1. Capacité (20) à électrodes métalliques intégrée sur un substrat de silicium (10), comprenant des couches métalliques (1, 3) de première et de deuxième électrodes et un diélectrique (2), caractérisée en ce que le diélectrique comprend au moins deux couches (2-1, 2-2) de diélectriques ayant des permittivités ($\varepsilon$) évoluant de façon opposée en fonction du champ électrique, le rapport des épaisseurs (dl, d2) de chaque couche diélectrique étant choisi de manière que la capacité présente une linéarité en tension satisfaisante n'excédant pas 20 $10^{-6}$/V.

2. Capacité selon la revendication 1, caractérisée en ce que le diélectrique comprend une couche d'oxyde de silicium (Si02) et une couche de nitrure de silicium (SiN).

3. Capacité selon l'une des revendications 1 et 2, dans laquelle les couches de diélectriques sont séparées par une couche conductrice intercalaire.

4. Capacité selon l'une des revendications 1 à 3, dans laquelle le matériau constituant les couches (1, 3) de première et de deuxième électrodes est choisi dans le groupe comprenant l'aluminium, le cuivre, le tungstène, le titane, le nitrure de titane et leurs alliages.

5. Combinaison d'au moins deux capacités à électrodes métalliques intégrées sur un substrat de silicium, caractérisée en ce que les capacités comportent des diélectriques différents ayant des permittivités ($\varepsilon$) évoluant de façon opposée en fonction du champ électrique, le rapport des épaisseurs (d1, d2) de chaque diélectrique étant choisi de manière que la capacité résultante formée par la combinaison présente une linéarité en tension satisfaisante n'excédant pas 20 10$^{-6}$/V.

6. Combinaison selon la revendication 5, comprenant au moins deux capacités en série.

7. Combinaison selon la revendication 5, comprenant au moins deux capacités en parallèle.

8. Combinaison selon l'une des revendications 5 à 7, dans laquelle le diélectrique d'une capacité est de l'oxyde de silicium ($SiO_2$) et le diélectrique de l'autre capacité est du nitrure de silicium (SiN).

9. Procédé de fabrication d'une capacité (20) à électrodes métalliques intégrée sur un substrat de silicium (10), comprenant une étape de dépôt d'une couche métallique (1) de première électrode, une étape de dépôt d'un diélectrique (2), et une étape de dépôt d'une couche métallique de deuxième électrode (3), l'étape de dépôt du diélectrique (2) comprenant au moins une étape de dépôt d'une couche (2-1) d'un premier diélectrique et une étape de dépôt d'une couche (2-2) d'un deuxième diélectrique, les premier et deuxième diélectriques ayant des permittivités ($\varepsilon$) évoluant de façon opposée en fonction du champ électrique, caractérisé en ce que le rapport (d1/d2) des épaisseurs (d1, d2) de chaque couche de diélectrique est choisi de manière que la capacité présente une linéarité en tension satisfaisante n'excédant pas 20 10$^{-6}$/V.

10. Procédé selon la revendication 9, dans lequel le rapport (d1/d2) des épaisseurs de chaque couche diélectrique (2-1, 2-2) est déterminé par des essais préalables, en observant la linéarité en tension de capacités de test comprenant des rapports d'épaisseurs (d1/d2) différents.

11. Procédé selon l'une des revendications 9 à 10, caractérisé en ce que les diélectriques sont de l'oxyde de silicium ($SiO_2$) et du nitrure de silicium (SiN).

12. Procédé selon l'une des revendications 9 à 11, dans lequel les couches de diélectriques sont déposées en phase vapeur.

13. Procédé selon l'une des revendications 9 à 12, dans lequel les couches de première et de deuxième électrodes sont constituées par un matériau choisi dans le groupe comprenant l'aluminium, le cuivre, le tungstène, le titane, le nitrure de titane et leurs alliages.

FIG.1

FIG.2

FIG.4

FIG.3A

FIG.3B

FIG.3C

FIG.3D

# EP 1 102 328 A1

**Office européen des brevets**

## RAPPORT DE RECHERCHE EUROPEENNE

Numéro de la demande

EP 00 12 3636

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 4 907 046 A (OHJI ET AL.)<br>6 mars 1990 (1990-03-06)<br>* le document en entier *<br>--- | 1,2,9-12 | H01L29/92 |
| A | T. WATANABE ET AL.: "Stacked SiO2/Si3N4/SiO2 dielectric layer for reliable memory capacitor"<br>INTERNATIONAL ELECTRON DEVICES MEETING TECHNICAL DIGEST 1984,<br>9 - 12 décembre 1984, pages 173-176,<br>XP002143980<br>san francisco, ca, usa<br>* le document en entier *<br>--- | 1,2,9-12 | |
| A | WO 98 00871 A (GENNUM CORPORATION)<br>8 janvier 1998 (1998-01-08)<br>* page 11, ligne 21 - page 12, ligne 2;<br>figure 8A *<br>--- | 1-3,5-8 | |
| A | EP 0 892 442 A (FRANCE TELECOM ;ST MICROELECTRONICS SA (FR))<br>20 janvier 1999 (1999-01-20)<br>* le document en entier *<br>----- | 1,4,9,13 | DOMAINES TECHNIQUES RECHERCHES (Int.Cl.7)<br><br>H01L |

Le présent rapport a été établi pour toutes les revendications

| Lieu de la recherche | Date d'achèvement de la recherche | Examinateur |
|---|---|---|
| LA HAYE | 1 mars 2001 | Baillet, B |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**          EP 00 12 3636

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-03-2001

| Document brevet cité au rapport de recherche | | Date de publication | Membre(s) de la famille de brevet(s) | | Date de publication |
|---|---|---|---|---|---|
| US 4907046 | A | 06-03-1990 | JP<br>JP<br>KR | 3020502 B<br>64000756 A<br>9205632 B | 15-03-2000<br>05-01-1989<br>10-07-1992 |
| WO 9800871 | A | 08-01-1998 | US<br>AU<br>EP<br>JP | 5745335 A<br>3250097 A<br>0913001 A<br>2000514243 T | 28-04-1998<br>21-01-1998<br>06-05-1999<br>24-10-2000 |
| EP 0892442 | A | 20-01-1999 | FR<br>JP<br>JP<br>US | 2766294 A<br>3101248 B<br>11074462 A<br>6136640 A | 22-01-1999<br>23-10-2000<br>16-03-1999<br>24-10-2000 |

EPO FORM P0460

Pour tout renseignement concernant cette annexe : voir Journal Officiel de l'Office européen des brevets, No.12/82